# EUROPÄISCHE PATENTSCHRIFT

(11) **EP 2 006 964 B1**
(45) Veröffentlichungstag und Bekanntmachung des Hinweises auf die Patenterteilung: **23.11.2011**
(21) Anmeldenummer: 08010552.1
(22) Anmeldetag: 11.06.2008
(51) Int. Cl.: H01S 5/14, H01S 5/022

(54) **Abstimmbares Diodenlasersystem mit externem Resonator**
Tunable diode laser system with external resonator
Système de laser à diodes réglable doté d'un résonateur externe

(30) Priorität: 18.06.2007 DE 102007028499
(43) Veröffentlichungstag der Anmeldung: 24.12.2008
(73) Patentinhaber: TOPTICA Photonics AG, 82166 Gräfelfing (DE)
(72) Erfinder: Heine, Thomas, 1160 Wien (AT); Heidemann, Rainer, 81371 München (DE)
(74) Vertreter: Isfort, Olaf

(56) Entgegenhaltungen:
- DE-A1- 19 860 895
- DE-A1- 19 935 612
- JP-A- 11 293 202
- JP-A- 2000 036 117
- JP-A- 2004 301 755
- US-A- 5 408 493
- US-A- 5 802 085
- US-A- 6 049 554
- US-A1- 2006 227 821

## Beschreibung

Die Erfindung betrifft ein abstimmbares Diodenlasersystem mit externem Resonator in Littrow- oder Littman-Konfiguration, mit einem optischen Gitter, an dem der Lichtstrahl einer Laserdiode gebeugt wird, einem Halteelement zur Halterung des Gitters bzw. zur Halterung eines Spiegels, der das an dem Gitter gebeugte Licht reflektiert, und mit einem Aktuator zur Veränderung der Position des Gitters bzw. des Spiegels.

Durch die Rückkopplung des Lichtes, das von einer Laserdiode eines Diodenlasers mit externem Resonator emittiert wird, kann die spektrale Bandbreite der Laseremission deutlich reduziert werden. Ein externer Resonator ermöglicht darüber hinaus das Abstimmen der Laserwellenlänge. Aus dem Stand der Technik bekannt sind Konfigurationen mit Rückkopplung über ein optisches Gitter, an dem das mittels der Laserdiode erzeugte Licht gebeugt wird. Das Gitter kann an der Vorderseite der Laserdiode, d.h. im Nutzstrahl, oder an der Rückseite der Laserdiode angeordnet sein, wobei im letzteren Fall die Rückkopplung über die Endfacette der Laserdiode erfolgt.

Bei Diodenlasern in so genannter Littrow-Konfiguration wird das von der Laserdiode emittierte Licht mittels einer Kollimationsoptik kollimiert und an dem optischen Gitter gebeugt. Das Licht der nullten Beugungsordnung wird als Nutzstrahl ausgekoppelt, das Licht der ersten Beugungsordnung wird hingegen in die Laserdiode zurückreflektiert, so dass das Beugungsgitter und die Endfacette der Laserdiode einen Resonator bilden. Die Abstimmung der Wellenlänge erfolgt bei einem Diodenlaser in Littrow-Konfiguration durch Drehung des optischen Gitters. Diese Drehung bewirkt eine Änderung des Einfallswinkels des Laserstrahls auf das Gitter und folglich eine Variation der Wellenlänge der resonant zurückgekoppelten ersten Beugungsordnung. Um das Diodenlasersystem modensprungfrei zu verstimmen, muss gleichzeitig mit der Änderung des Drehwinkels des Beugungsgitters die Länge des optischen Resonators variiert werden, so dass stets dieselbe Lasermode im Resonator vorherrscht. Eine koordinierte Winkel- und Längenänderung ist genau dann realisiert, wenn das Beugungsgitter um ein Drehzentrum gedreht wird, das durch die Schnittlinie der Ebenen der Oberfläche des optischen Gitters und der Endfacette der Laserdiode definiert ist. In der Praxis ist eine solche Drehachse nachteiligerweise nicht oder nur mit großem Aufwand akkurat realisierbar. Zudem führt der notwendigerweise lange Dreharm des Beugungsgitters zu einer sehr großen Bauform. Dies wiederum führt nachteiligerweise dazu, dass das System empfindlich auf niederfrequente mechanische Schwingungen reagiert und thermisch nur schwer kontrollierbar ist. Der lange Dreharm ist außerdem nachteilig, weil es aufgrund beim Transport einwirkender Kräfte leicht zur Dejustage kommen kann.

Des Weiteren sind Diodenlasersysteme in der so genannten Littman-Konfiguration bekannt. Bei diesen Systemen wird der von einer Laserdiode emittierte Laserstrahl ebenfalls an einem optischen Gitter gebeugt, wobei jedoch das Licht der ersten Beugungsordnung auf einen Spiegel fällt, der das Licht auf das Beugungsgitter zurückreflektiert. Der Spiegel bildet mit der Endfacette der Laserdiode einen optischen Resonator. Zur Abstimmung der Wellenlänge wird der Spiegel gedreht. Durch diese Drehung ändert sich der Winkel zwischen dem gebeugten Strahl erster Ordnung und der Normalen des optischen Gitters. Hierdurch wird die Resonanzbedingung vorgegeben. Zum modensprungfreien Abstimmen der Wellenlänge muss bei einem Diodenlasersystem in Littman-Konfiguration der Spiegel um ein Drehzentrum gedreht werden, das durch die Schnittlinie dreier Ebenen definiert ist. Dies sind die Ebene der Endfacette der Laserdiode, die Ebene der Oberfläche des Beugungsgitters und die Ebene der Oberfläche des Spiegels. Die akkurate Realisierung dieses Drehzentrums erfordert in der Praxis eine sehr aufwendige Mechanik. Die Fertigung und Wartung solcher Lasersysteme ist entsprechend teuer und zeitintensiv. Eine fehlerhafte Position des Drehzentrums schränkt den modensprungfreien Abstimmbereich deutlich ein.

Ein abstimmbares Diodenlasersystem der eingangs angegebenen Art, bei dem zur Veränderung der Position des Gitters Aktuatoren vorgesehen sind, ist aus dem Stand der Technik bekannt (J. Hult et al.: "Wide-bandwidth mode-hop-free tuning of extended-cavity GaN diode lasers", Applied Optics, 20.06.2005, Bd. 44, Nr. 18, S. 3675-3679). Bei dem vorbekannten System ist ein Halteelement zur Halterung des Beugungsgitters vorgesehen. Das Halteelement umfasst zwei Piezoaktuatoren, die eine Drehung des Beugungsgitters und eine synchrone Änderung der Länge des optischen Resonators bewirken. Die Drehung erfolgt um ein (virtuelles) Drehzentrum, das durch die Ansteuerung der Piezoaktuatoren definiert ist. Nachteilig ist bei diesem System, dass zwei separate Piezoaktuatoren erforderlich sind. Die korrekte Ansteuerung der Piezoaktuatoren zur Realisierung einer modensprungfreien Abstimmbarkeit ist kompliziert, was eine entsprechend aufwendige Elektronik erforderlich macht. Das System ist dadurch aufwendig und teuer in der Herstellung.

Aus der US 2006/0227821 A1 ist ein Diodenlasersystem mit externem Resonator in Littrow-Konfiguration bekannt, bei dem ein Festkörpergelenk in Form eines Wagenradgelenks zum Einsatz kommt, um eine Drehung des Beugungsgitters um eine durch das Wagenradgelenk verlaufende Drehachse zum Zwecke der Abstimmung des Diodenlasersystems hinsichtlich der Wellenlänge zu ermöglichen.

Die US 5,802,085 offenbart eine abstimmbare Laserlichtquelle, wiederum in Gestalt eines Diodenlasers mit externem Resonator in Littrow-Konfiguration. Das Beugungsgitter ist an einem beweglichen Träger angeordnet, in einer Weise, die eine durch einen einzigen Aktuator bewirkte synchrone Translation und Rotation ermöglicht.

Die US 6,049,554 beschreibt ebenfalls einen abstimmbaren Diodenlaser mit externem Resonator, bei dem die Wellenlänge durch gleichzeitige Rotation und lineare Translation eines Reflektors selektierbar ist. Durch geeignete Wahl des Drehzentrums der Bewegung ist der Diodenlaser über einen breiten Spektralbereich kontinuierlich abstimmbar.

Vor diesem Hintergrund ist es die Aufgabe der Erfindung, ein abstimmbares Diodenlasersystem bereitzustellen, das eine zuverlässige modensprungfreie Abstimmbarkeit ermöglicht und außerdem einfach und kostengünstig realisierbar ist.

Diese Aufgabe löst die Erfindung durch ein abstimmbares Diodenlasersystem mit externem Resonator in Littrow-Konfiguration gemäß Patentanspruch 1 sowie durch ein abstimmbares Diodenlasersystem in Littman-Konfiguration gemäß Patentanspruch 2.

Bei dem erfindungsgemäßen Diodenlasersystem kann ein kontinuierliches modensprungfreies Abstimmen der Wellenlänge mittels eines einzigen Aktuators erfolgen. Das Beugungsgitter (in Littrow-Konfiguration) bzw. der Spiegel (in Littman-Konfiguration) werden zuverlässig um das korrekte Drehzentrum herum gedreht. Gemäß der Erfindung umfasst das Halteelement einen Träger für das Gitter bzw. für den Spiegel und einen Grundkörper, wobei der Träger mit dem Grundkörper über Gelenke, nämlich Festkörpergelenke, verbunden ist. Die Anordnung und Auslegung dieser Gelenke bestimmt, wie die lineare Auslenkung des Aktuators in eine Drehbewegung des Trägers umgesetzt wird. Die Anordnung und Auslegung der Gelenke sowie die Position des Einwirkpunktes des Aktuators an dem Träger definieren präzise und reproduzierbar das Drehzentrum. Das Drehzentrum liegt dabei außerhalb der Gelenke und außerhalb des Grundkörpers des Halteelements. Das bedeutet, dass das (virtuelle) Drehzentrum außerhalb einer Fläche, die von den Gelenken aufgespannt wird und außerhalb der äußeren Umgrenzung des Grundkörpers liegt. Dies ermöglicht vorteilhafterweise einen besonders kompakten Aufbau.

Das erfindungsgemäße Lasersystem kommt mit einem einzigen Aktuator aus. Eine aufwendige Ansteuerungselektronik zur koordinierten Auslenkung mehrerer Aktuatoren ist bei dem erfindungsgemäßen System nicht erforderlich. Im Übrigen umfasst das erfindungsgemäße System nur wenige mit vergleichsweise geringem Aufwand herstellbare Komponenten, so dass das System insgesamt kostengünstig herstellbar ist.

Ein weiterer Vorteil des erfindungsgemäßen Systems ist, dass es aufgrund seiner kompakten Abmessungen vergleichsweise unempfindlich hinsichtlich mechanischer Schwingungen ist.

Die Gelenke des erfindungsgemäßen Diodenlasersystems sind elastische Festkörpergelenke, deren Steifigkeit über die Längen und die Dicken der Gelenkabschnitte gezielt vorgegeben werden kann. Die einzelnen Gelenke können unterschiedlich steif sein. Das (virtuelle) Drehzentrum kann bei der Herstellung des Halteelements durch entsprechende Dimensionierung der einzelnen Gelenke gezielt vorgegeben werden, ohne dass ansonsten die Mechanik angepasst werden müsste. Außerdem können durch die Auslegung der Gelenke hinsichtlich ihrer Steifigkeit die mechanischen Resonanzfrequenzen so beeinflusst werden, dass die Empfindlichkeit auf mechanische Schwingungen gering ist und eine besonders schnelle Abstimmung der Wellenlänge mittels des Aktuators möglich ist.

Ein weiterer Vorteil der Festkörpergelenke ist, dass diese quasi verschleißfrei arbeiten, was eine gute Langzeitstabilität des Systems sicherstellt. Aufgrund der elastischen Eigenschaften der Festkörpergelenke kann außerdem der zur Drehung des Gitters bzw. des Spiegels erforderliche Stellmechanismus besonders einfach realisiert werden. Für die Drehung muss nämlich lediglich in einer Richtung eine Kraft mittels des Aktuators gegen die elastischen Rückstellkräfte der Festkörpergelenke ausgeübt werden. Die Rückstellkräfte sorgen dann automatisch für die Langzeitstabilität der Abstimmung. Zweckmäßigerweise sind bei dem erfindungsgemäßen Lasersystem der Träger und der Grundkörper miteinander einstückig (monolithisch) ausgebildet. Zur Herstellung können bekannte Elektroerosionsverfahren, wie beispielsweise die Drahterosion, eingesetzt werden. Dies wirkt sich wiederum günstig auf die Kosten und gleichzeitig auf die Kompaktheit der Gesamtanordnung aus.

Bei dem erfindungsgemäßen Diodenlasersystem sind als Festkörpergelenke Führungsgelenke und wenigstens ein Drehungsgelenk vorgesehen. Die Führungsgelenke bewirken eine Führung des Trägers in der Ebene des Lichtstrahls, während das Drehungsgelenk dafür sorgt, dass die lineare Auslenkung des Aktuators in eine Drehung des Trägers um das gewünschte Drehzentrum herum umgesetzt wird. Die Führungsgelenke ermöglichen also eine Translation und Rotation in der Ebene des Lichtstrahls. Das Drehungsgelenk "fesselt" den Träger an den Grundkörper, was die erfindungsgemäße Umsetzung der linearen Auslenkung des Aktuators in eine Drehung um das außerhalb des Grundkörpers liegende Drehzentrum bewirkt.

Die Festkörpergelenke können beispielsweise als Platten- oder Blattfedergelenke ausgebildet sein. Solche Gelenke haben translatorische und rotatorische Freiheitsgrade, wobei die Biegesteifigkeit der Gelenke in der Ebene des Laserstrahls vorteilhafterweise um Größenordnungen kleiner ist als in der dazu senkrechten Richtung. Hierdurch lässt sich die Führung der zur Abstimmung erforderlichen Drehung des Gitters bzw. des Spiegels gezielt bewirken.

Gemäß einer besonders bevorzugten Ausgestaltung des erfindungsgemäßen abstimmbaren Diodenlasersystems ist vorgesehen, dass die Position des Drehzentrums durch Veränderung der Position des Einwirkpunktes des Aktuators an dem Träger justierbar ist. Bei dem erfindungemäßen System kann sehr einfach die Position des Drehzentrums dadurch justierbar ausgestaltet werden, dass die Position des Aktuators und damit die Position des Einwirkpunktes des Aktuators an dem Träger veränderbar ist. Die Justierung kann vorteilhaft in der Weise erfolgen, dass die Position des Einwirkpunktes in einer Richtung parallel zur Gitteroberfläche verändert wird. Dadurch kann das tatsächliche Drehzentrum zumindest näherungsweise mit dem theoretisch idealen Drehzentrum zur Deckung gebracht werden. Es wird gemäß der Erfindung ausgenutzt, dass die Position des Einwirkpunktes in wohl definierter Art und Weise die Umsetzung der linearen Auslenkung des Aktuators in die Drehung des Trägers, an dem das Beugungsgitter bzw. der Spiegel befestigt ist, beeinflusst.

Bei dem erfindungsgemäßen abstimmbaren Diodenlasersystem kann der die Abstimmung bewirkende Aktuator im einfachsten Fall eine manuell zu betätigende Stellschraube sein, die in einem passenden Gewinde in dem Grundkörper des Halteelements geführt ist und je nach Einschraubtiefe die Position des Trägers festlegt. Ebenso kommen als Aktuator ein linearer Stellmotor oder ein linearer Piezoaktuator in Frage.

Besonders bevorzugt ist eine Ausgestaltung des erfindungsgemäßen Diodenlasersystems, bei dem das Halteelement außerdem ein Drehgestell umfasst, an dem der Grundkörper in der Ebene des Lichtstrahls drehbar gelagert ist. Diese Ausgestaltung ermöglicht zusätzlich eine sehr einfache (grobe) Durchstimmung des Lasersystems durch Drehung des Grundkörpers (und damit des Gitters bzw. des Spiegels) relativ zu dem Drehgestell. Das Halteelement ist dabei zweckmäßigerweise so ausgestaltet, dass die Drehung des optischen Gitters beziehungsweise des Spiegels um den Auftreffpunkt des Laserstrahls auf das Gitter bzw. auf den Spiegel herum erfolgt. Es kann in diesem Fall ein kleines Gitter bzw. ein kleiner Spiegel verwendet werden, was durch die entsprechend kleine Baugröße des Trägers die Resonanzfrequenz der Anordnung erhöht und damit die Empfindlichkeit auf mechanische (akustische) Schwingungen verringert.

Eine zweckmäßige Weiterbildung des erfindungsgemäßen Diodenlasersystems sieht vor, dass ein Diodenhalter zur Halterung der Laserdiode und einer Kollimationsoptik vorgesehen ist. Der Diodenhalter umfasst die Laserdiode und die Kollimationsoptik, wobei zweckmäßigerweise die Position der Laserdiode relativ zur Kollimationsoptik justierbar sein sollte, um den bestmöglichen Laserstrahl zu erhalten. Der Diodenhalter ist zur Justierung des Auftreffwinkels auf das Gitter drehbar. Dabei geht es vor allem darum, dafür Sorge zu tragen, dass der Lichtstrahl in der Weise auf das Beugungsgitter auftrifft, dass die gewünschte Rückkopplung des gebeugten Lichtes in die Laserdiode hergestellt wird. Eine besonders zweckmäßige Ausgestaltung des erfindungsgemäßen Lasersystems sieht vor, dass der Diodenhalter an dem Drehgestell drehbar gelagert ist, und zwar um eine zur Drehachse des Grundkörpers senkrechte Drehachse. Hierdurch ergibt sich insgesamt ein sehr kompakter und geschlossener Aufbau. Alle Komponenten können so aneinander festgelegt und fixiert werden, dass eine hohe Langzeitstabilität der vorgenommen Justierung gewährleistet ist. Eine hohe Transportstabilität ist gewährleistet, da kaum Drehmomente um die Drehachse des an dem Drehgestell gelagerten Diodenhalters zu erwarten sind.

Laserdioden im Sinne der Erfindung sind beliebige Halbleiterlaser, wie z.B. Fabry-Perot Laserdioden, Antireflex-beschichtete (AR) Laserdioden, Dioden mit trapezförmiger Geometrie der aktiven Zone, Breitstreifenemitter oder dergleichen.

Ein Ausführungsbeispiel der Erfindung wird im Folgenden anhand der beigefügten Zeichnungen näher erläutert. Es zeigen:
- Fig. 1: Explosionsdarstellung eines erfindungs- gemäßen Diodenlasersystems in Littrow- Konfiguration;
- Fig. 2: Draufsicht auf das Halteelement des erfindungsgemäßen Lasersystems mit daran angebrachtem Diodenhalter;
- Fig. 3: teilweise geschnittene Draufsicht auf den Grundkörper und den Träger des Halteelements;
- Fig. 4: Anbringung der Laserdiode an dem Diodenhalter;
- Fig. 5: Anbringung der Kollimationsoptik an dem Diodenhalter;
- Fig. 6: Halteelement des erfindungsgemäßen Diodenlasersystems mit daran festge- klemmtem Diodenhalter in Draufsicht.

Die Figuren zeigen ein erfindungsgemäßes abstimmbares Diodenlasersystem mit externem Resonator in Littrow-Konfiguration.

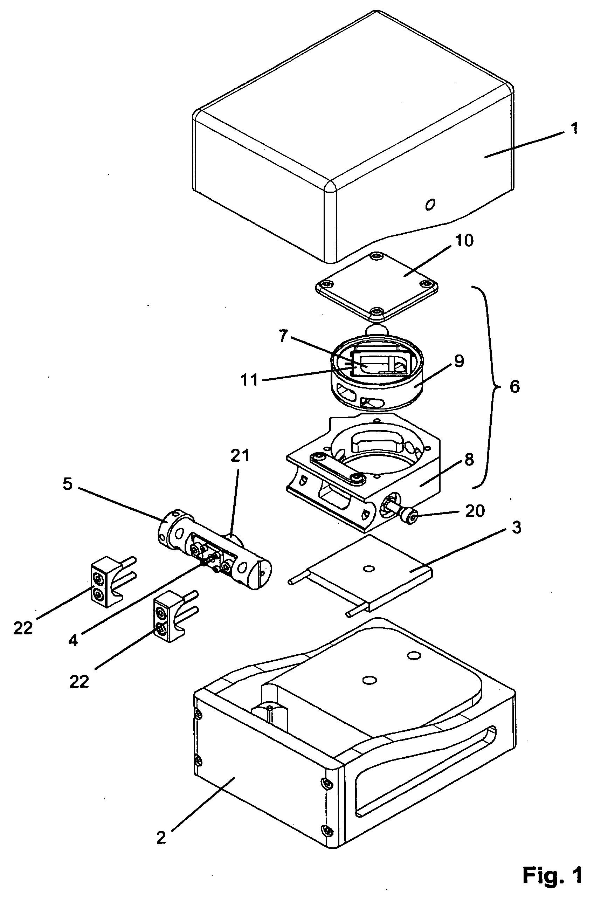

Die Explosionsdarstellung gemäß Fig. 1 zeigt die wesentlichen Einzelteile des Systems. Ein Deckel 1 sowie eine Basisplatte 2 bilden das äußere Gehäuse des Systems. In der Basisplatte 2 sind die elektrischen Anschlüsse untergebracht. Zur Temperaturstabilisierung des Laserresonators dient ein Peltierelement 3. Die zentralen Komponenten des erfindungsgemäßen Diodenlasersystems sind eine Laserdiode 4, die an einem Diodenhalter 5 angeordnet ist, sowie ein Halteelement 6 zur Halterung eines optischen Gitters 7. Das Halteelement umfasst ein Drehgestell 8 sowie einen Grundkörper 9. Der Grundkörper 9 ist an dem Drehgestell 8 um eine vertikale Drehachse drehbar gelagert. Hierzu wird der kreisrunde Grundkörper 9 in die dazu korrespondierende Ausnehmung in dem Drehgestell 8 eingesetzt. Die Wellenlänge des von dem Diodenlasersystem emittierten Lichtes ist durch Drehung des Grundkörpers 9 relativ zu dem Drehgestell 8 grob durchstimmbar. Dabei erfolgt die Drehung des Grundkörpers 9 um den Auftreffpunkt des Laserlichtstrahls der Laserdiode 4 auf das Beugungsgitter 7 herum. Auf das Haltelement 6 ist ein Resonatordeckel 10 aufgeschraubt, um den Grundkörper 9 in vertikaler Richtung zu fixieren.

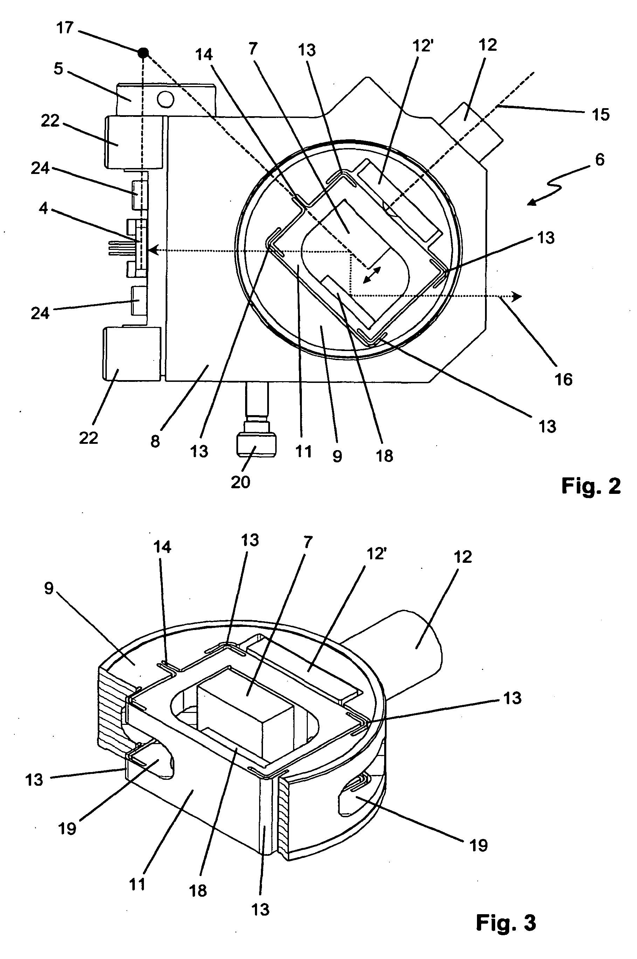

Zentrales Element des erfindungsgemäßen Diodenlasers ist das Halteelement 6, dessen Aufbau im Detail in den Fig. 2 und 3 dargestellt ist. Das Halteelement 6 umfasst einen Träger 11, an dem das optische Gitter 7 angeordnet ist. Zur Veränderung der Position des Gitters 7 ist ein Piezoaktuator 12 vorgesehen, der sich an dem Grundkörper 9 abstützt und auf den Träger 11 einwirkt. Der Grundkörper 9 ist mit dem Träger 11 über insgesamt fünf Festkörpergelenke verbunden. Dies sind vier symmetrisch angeordnete Führungsgelenke 13 und ein Drehungsgelenk 14, das seitlich versetzt zur Auslenkungsachse 15 des Aktuators 12 angeordnet ist. Die vier Führungsgelenke 13 dienen der Führung des Trägers 11 in der Ebene des Lichtstrahls 16 der Laserdiode 4 und bestimmen im Wesentlichen die mechanischen Resonanzfrequenzen des Systems. Das Drehungsgelenk 14 sorgt dafür, dass eine lineare Auslenkung des Aktuators 12 entlang der Achse 15 in eine Drehung des Trägers 11 umgesetzt wird. Dabei liegt das Drehzentrum 17 dieser Drehung, wie in der Fig. 2 dargestellt, außerhalb der Gelenke 13, 14 und insbesondere auch außerhalb der äußeren Umgrenzung des Grundkörpers 9. Das Drehzentrum ist definiert durch die Schnittlinie der Ebene der Oberfläche des Beugungsgitters 7 und der Ebene der Endfacette der Laserdiode 4. Die Drehung um das Drehzentrum 17 ermöglicht, wie oben erläutert, eine modensprungfreie Abstimmung der Laserwellenlänge. Die Position des Drehzentrums 17 ist durch Veränderung der Position des Einwirkpunktes des Aktuators 12 an dem Träger 11 in einer Richtung parallel zur Ebene des Gitters 7 und auch parallel zu dem Drehungsgelenk 14 justierbar. Bei dem dargestellten Ausführungsbeispiel liegt das Drehungsgelenk 14 in der Ebene des Gitters 7. Der Einwirkpunkt ist definiert durch den Schnittpunkt der Auslenkungsachse 15 des Aktuators 12 mit der seitlichen Oberfläche des Trägers 11. Durch einfaches Verschieben einer Piezopfatte 12' des Aktuators 12 kann der Einwirkpunkt variiert werden. Dadurch lässt sich die Position des Drehzentrums 17 fein einstellen und (zumindest näherungsweise) mit dem theoretisch idealen Drehzentrum zur Deckung bringen.

In der Fig. 2 ist der Strahlengang des Laserlichts dargestellt. Der Laserstrahl 16 trifft auf das Beugungsgitter 7 auf. Das Licht der nullten Beugungsordnung wird als Nutzstrahl ausgekoppelt und verlässt das Lasersystem. Die erste Beugungsordnung hingegen wird in die Laserdiode 4 zurückreflektiert, so dass das Gitter 7 und die Endfacette der Laserdiode 4 einen optischen Resonator bilden. Der Nutzstrahl wird an einem Umlenkspiegel 18 zusätzlich reflektiert. Der Umlenkspiegel 18 ist, wie in den Figuren zu erkennen ist, an dem Träger 11 angeordnet, so dass die Position des Umlenkspiegels 18 relativ zu dem Beugungsgitter 7 fixiert ist. Der Umlenkspiegel kompensiert die Winkeländerung des Laserstrahls bei der Abstimmung des Lasersystems. Die Winkeländerung wird in einen geringen Strahlversatz umgewandelt.

Wie in der Fig. 3 zu erkennen ist, sind in dem Grundkörper 9 und in dem Träger 11 Lichteintritts- und -austrittsöffnungen 19 für den Laserstrahl ausgebildet. Dazu korrespondierende Öffnungen weist das Drehgestell 8 auf. Insgesamt wird somit der Laserstrahl im Inneren des Halteelements 6 geführt.

Zur groben Durchstimmung ist, wie oben erläutert, der Grundkörper 9 an dem Drehgestell 8 drehbar gelagert. Zur Durchstimmung dient eine mechanische Stellschraube 20, die in das Drehgestell 8 einschraubbar ist. Die Stellschraube 20 wirkt auf den Grundkörper 9 ein, und zwar gegen die Kraft einer (nicht dargestellten) Rückstellfeder. Die Drehung erfolgt um eine vertikale Drehachse, die durch den Auftreffpunkt des Laserstrahls 16 auf das Gitter 7 verläuft. Dies ermöglicht es, ein klein dimensioniertes Beugungsgitter 7 zu verwenden, so dass insgesamt eine sehr kompakte Bauform erzielt wird.

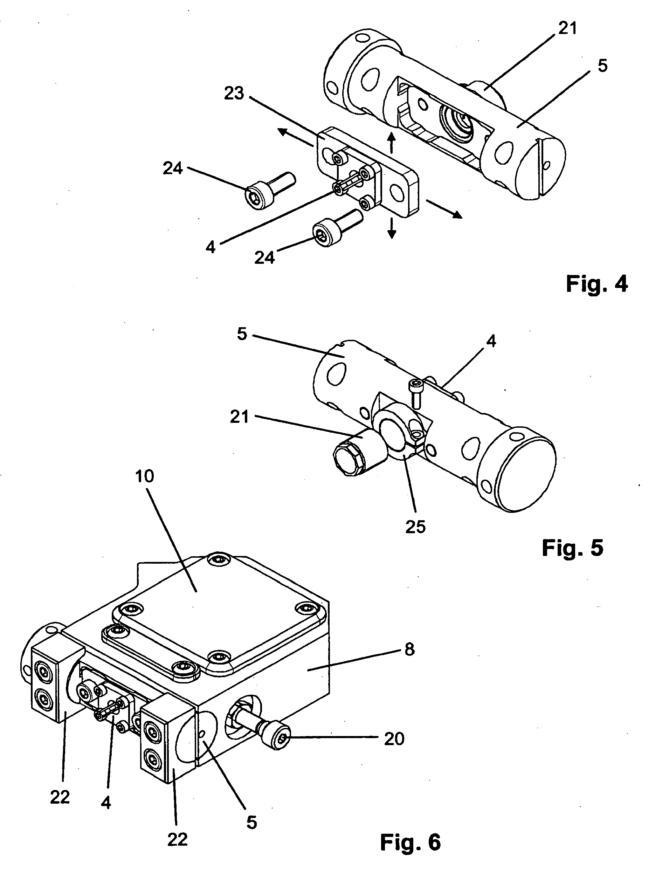

In den Fig. 4 und 5 ist der Diodenhalter 5 des erfindungsgemäßen Lasersystems im Detail dargestellt. Der Diodenhalter 5 dient zur Halterung der Laserdiode 4 und der Kollimationsoptik 21. Der Diodenhalter 5 ist (zumindest in den Bereichen, in denen er an dem Drehgestell 8 geführt ist) im Wesentlichen zylindrisch ausgebildet. Das Drehgestell 8 weist seitlich eine zu der Form des Diodenhalters 5 korrespondierende (halb-)zylindrische Ausnehmung auf. Diese nimmt den Diodenhalter 5, wie in den Fig. 6 und 7 gezeigt, auf. Zur Festlegung des Diodenhalters 5 an dem Drehgestell 8 dienen mit dem Drehgestell 8 verschraubbare Klemmklötze 22. Der Diodenhalter ist auf diese Weise um eine horizontale Drehachse an dem Drehgestell 8 drehbar gelagert. Die Richtung des Laserstrahls lässt sich in einer vertikalen Ebene justieren, um die Rückkopplung des an dem optischen Gitter 7 gebeugten Lichtes in die Laserdiode 4 herzustellen. In der gewünschten Stellung wird der Diodenhalter 5 mittels der Klemmklötze 22 fixiert. Die einmal vorgenommene Justierung hat eine gute Langzeitstabilität, da Drehmomente um die Drehachse des Diodenhalters 5 selbst bei starken mechanischen Beanspruchungen, wie beispielsweise durch Stöße beim Transport, kaum auftreten. Durch die großen Kontaktflächen zwischen dem Diodenhalter 5 und dem Drehgestell 8 ist ein guter Wärmeübergang sichergestellt. Die insgesamt sehr kompakte und geschlossene Einheit aus Diodenhalter 5, Drehgestell 8, Grundkörper 9, Träger 11 und Resonatordeckel 10 bewirkt eine äußerst geringe thermische Frequenzdrift des Lasersystems sowie eine geringe Empfindlichkeit auf niederfrequente (akustische) mechanische Schwingungen.

Wie die Fig. 4 und 5 weiterhin zeigen, ist die Laserdiode 4 mittels einer Klemmplatte 23 relativ zur Kollimationsoptik 21 in transversaler Richtung justierbar. In der gewünschten Stellung wird die Klemmplatte 23 mittels zweier Schrauben 24 an dem Diodenhalters 5 fixiert. Die Kollimationsoptik 21 ist parallel zur optischen Achse verschiebbar. Mittels eines Klemmrings 25 ist die Kollimationsoptik in der gewünschten Stellung dauerhaft fixierbar. Bei der Kollimationsoptik handelt es sich im einfachsten Fall um eine Linse.

## Patentansprüche

1. Abstimmbares Diodenlasersystem mit externem Resonator in Littrow-Konfiguration, mit einem optischen Gitter (7), an dem der Lichtstrahl (16) einer Laserdiode (4) gebeugt wird, und einem Halteelement (6) zur Halterung des Gitters (7), wobei das System einen einzigen Aktuator (12) zur Veränderung der Position des Gitters (7) aufweist, wobei das Halteelement (6) einen Träger (11), an dem das Gitter (7) angeordnet ist, und einen Grundkörper (9) umfasst, wobei der Träger (11) mit dem Grundkörper (9) über Gelenke (13, 14) verbunden ist und es sich bei den Gelenken (13, 14) um Festkörpergelenke handelt, die translatorische und rotatorische Freiheitsgrade haben,
**dadurch gekennzeichnet,**
**dass** der Aktuator (12) auf den Träger (11) einwirkt und sich an dem Grundkörper (9) abstützt, und zwar in einer Weise, dass eine lineare Auslenkung des Aktuators (12) in Richtung einer Auslenkungsachse (15) in eine Drehung des Trägers (11) in der durch den Lichtstrahl von der Laserdiode zum Gitter (7) und den vom Gitter (7) gebeugten Lichtstrahl aufgespannten Ebene des Lichtstrahls (16) umgesetzt wird, wobei das Drehzentrum (17) außerhalb einer Fläche, die von den Gelenken (13, 14) aufgespannt wird, und außerhalb der äußeren Umgrenzung des Grundkörpers (9) liegt, und die Festkörpergelenke beiderseits der Auslenkungsachse (15) angeordnete Führungsgelenke (13) und ein Drehungsgelenk (14), das seitlich versetzt zur Auslenkungsachse (15) angeordnet ist, umfassen.

2. Abstimmbares Diodenlasersystem mit externem Resonator in Littman-Konfiguration, mit einem optischen Gitter (7), an dem der Lichtstrahl (16) einer Laserdiode (4) gebeugt wird, und mit einem Halteelement (6) zur Halterung eines Spiegels, der das an dem Gitter (7) gebeugte Licht reflektiert, wobei das System einen einzigen Aktuator (12) zur Veränderung der Position des Spiegels aufweist, wobei das Halteelement (6) einen Träger (11), an dem der Spiegel angeordnet ist, und einen Grundkörper (9) umfasst, wobei der Träger (11) mit dem Grundkörper (9) über Gelenke (13, 14) verbunden ist und es sich bei den Gelenken (13, 14) um Festkörpergelenke handelt, die translatorische und rotatorische Freiheitsgrade haben, wobei der Aktuator (12) sich an dem Grundkörper (9) abstützt und in einer Weise auf den Träger (11) einwirkt, dass eine lineare Auslenkung des Aktuators (12) in Richtung einer Auslenkungsachse (15) in eine Drehung des Trägers (11) in der durch den Lichtstrahl von der Laserdiode zum Gitter (7) und den vom Gitter (7) gebeugten Lichtstrahl aufgespannten Ebene des Lichtstrahls (16) umgesetzt wird, wobei das Drehzentrum (17) außerhalb einer Fläche, die von den Gelenken (13, 14) aufgespannt wird, und außerhalb der äußeren Umgrenzung des Grundkörpers (9) liegt, und die Festkörpergelenke beiderseits der Auslenkungsachse (15) angeordnete Führungsgelenke (13) und ein Drehungsgelenk (14), das seitlich versetzt zur Auslenkungsachse (15) angeordnet ist, umfassen.

3. Abstimmbares Diodenlasersystem nach Anspruch 1 oder 2, **dadurch gekennzeichnet, dass** die Festkörpergelenke unterschiedlich steif sind.

4. Abstimmbares Diodenlasersystem nach einem der Ansprüche 1 bis 3, **dadurch gekennzeichnet, dass** die Festkörpergelenke (13, 14) als Platten- oder Blattfedergeienke ausgebildet sind.

5. Abstimmbares Diodenlasersystem nach einem der Ansprüche 1 bis 4, **dadurch gekennzeichnet, dass** die Position des Drehzentrums (17) durch Veränderung der Position des Einwirkpunktes des Aktuators (12) an dem Träger (11) justierbar ist.

6. Abstimmbares Diodenlasersystem nach einem der Ansprüche 1 bis 5, **dadurch gekennzeichnet, dass** der Aktuator (12) ein linearer Stellmotor, ein linearer Piezoaktuator, oder eine Stellschraube ist.

7. Abstimmbares Diodenlasersystem nach einem der Ansprüche 1 bis 6, **dadurch gekennzeichnet, dass** das Halteelement (6) außerdem ein Drehgestell (8) umfasst, an dem der Grundkörper (9) in der Ebene des Lichtstrahls (16) drehbar gelagert ist.

8. Abstimmbares Diodenlasersystem nach Anspruch 7, **dadurch gekennzeichnet, dass** die Wellenlänge des von dem Diodenlasersystem emittierten Lichtes durch Drehung des Grundkörpers (9) relativ zu dem Drehgestell (8) durchstimmbar ist.

9. Abstimmbares Diodenlasersystem nach einem der Ansprüche 1 bis 8, **gekennzeichnet durch** einen Diodenhalter (5) zur Halterung der Laserdiode (4) und einer Kollimationsoptik (21), wobei der Diodenhalter (5) zur Justierung des Auftreffwinkels des Lichtstrahls (16) auf das Gitter (7) drehbar ist.

10. Abstimmbares Diodenlasersystem nach den Ansprüchen 8 und 9, **dadurch gekennzeichnet, dass** der Diodenhalter (5) an dem Drehgestell (8) drehbar gelagert ist, und zwar um eine zur Drehachse des Grundkörpers (9) senkrechte Drehachse.

11. Diodenlasersystem mit externem Resonator in Littrow- oder Littman-Konfiguration, nach einem der Ansprüche 1 bis 10, mit einem optischen Gitter (7), an dem der Lichtstrahl (16) einer Laserdiode (4) gebeugt wird, und einem Halteelement (6) zur Halterung des Gitters (7), wobei ein Diodenhalter (5) zur Halterung der Laserdiode (4) vorgesehen ist, wobei der Diodenhalter (5) zur Justierung des Auftreffwinkels des Lichtstrahls (16) auf das Gitter (7) an dem Halteelement (6) drehbar gelagert ist.

12. Diodenlasersystem nach Anspruch 11, **dadurch gekennzeichnet, dass** der Diodenhalter (5) im Wesentlichen zylindrisch ausgebildet ist, wobei das Halteelement (6) zur Aufnahme des Diodenhalters (5) eine zu dessen Form korrespondierende Ausnehmung aufweist.

13. Diodenlasersystem nach Anspruch 11 oder 12, **gekennzeichnet durch** wenigstens einen mit dem Halteelement (6) lösbar verbindbaren Klemmklotz (22) zur Festlegung des Diodenhalters (5) an dem Halteelement (6).

## Claims

1. A tunable diode laser system with an external resonator in a Littrow configuration comprising an optical grating (7) at which the light beam (16) of a laser diode (4) is diffracted, and a holding element (6) for holding the grating (7), wherein the system has a single actuator (12) for changing the position of the grating (7), wherein the holding element (6) includes a carrier (11) on which the grating (7) is arranged and a main body (9), wherein the carrier (11) is connected to the main body (9) by way of joints (13, 14) and the joints (13, 14) are solid-state joints which have translatory and rotary degrees of freedom,
**characterised in that**
the actuator (12) acts on the carrier (11) and is supported on the main body (9) more specifically in such a way that a linear deflection of the actuator (12) in the direction of a deflection axis (15) is converted into a rotation of the carrier (11) in the plane of the light beam (16), which plane is defined by the light beam from the laser diode to the grating (7) and the light beam diffracted by the grating (7), wherein the centre of rotation (17) is outside a surface which is spanned by the joints (13, 14) and outside the outer boundary of the main body (9), and the solid-state hinges include guide hinges (13) arranged on both sides of the deflection axis (15) and a rotary hinge (14) arranged laterally in displaced relationship with the deflection axis (15).

2. A tunable diode laser system with an external resonator in a Littrow configuration comprising an optical grating (7) at which the light beam (16) of a laser diode (4) is diffracted, and a holding element (6) for holding a mirror which reflects the light diffracted at the grating (7), wherein the system has a single actuator (12) for changing the position of the mirror, wherein the holding element (6) includes a carrier (11) on which the grating (7) is arranged and a main body (9), wherein the carrier (11) is connected to the main body (9) by way of joints (13, 14) and the joints (13, 14) are solid-state joints which have translatory and rotary degrees of freedom, wherein the actuator (12) is supported on the main body (9) and acts on the carrier (11) in such a way that a linear deflection of the actuator (12) in the direction of a deflection axis (15) is converted into a rotation of the carrier (11) in the plane of the light beam (16), which plane is defined by the light beam from the laser diode to the grating (7) and the light beam diffracted by the grating (7), wherein the centre of rotation (17) is outside a surface which is spanned by the joints (13, 14) and outside the outer boundary of the main body (9), and the solid-state hinges include guide hinges (13) arranged on both sides of the deflection axis (15) and a rotary hinge (14) arranged laterally in displaced relationship with the deflection axis (15).

3. A tunable diode laser system according to claim 1 or claim 2 **characterised in that** the solid-state joints are of differing rigidity.

4. A tunable diode laser system according to one of claims 1 to 3 **characterised in that** the solid-state joints (13, 14) are in the form of plate or leaf spring joints.

5. A tunable diode laser system according to one of claims 1 to 4 **characterised in that** the position of the centre of rotation (17) can be adjusted by changing the position of the point of action of the actuator (12) on the carrier (11).

6. A tunable diode laser system according to one of claims 1 to 5 **characterised in that** the actuator (12) is a linear servo motor, a linear piezo-actuator or an adjusting screw.

7. A tunable diode laser system according to one of claims 1 to 6 **characterised in that** the holding element (6) also includes a rotary support (8) on which the main body (9) is mounted rotatably in the plane of the light beam (16).

8. A tunable diode laser system according to claim 7 **characterised in that** the wavelength of the light emitted by the diode laser system can be tuned by rotation of the main body (9) relative to the rotary support (8).

9. A tunable diode laser system according to one of claims 1 to 8 **characterised by** a diode holder (5) for holding the laser diode (4) and an optical collimation means (21), wherein the diode holder (5) is rotatable for adjusting the angle of incidence of the light beam (16) on the grating (7).

10. A tunable diode laser system according to claims 8 and 9 **characterised in that** the diode holder (5) is mounted rotatably on the rotary support (8), more specifically about an axis of rotation perpendicular to the axis of rotation of the main body (9).

11. A diode laser system comprising an external resonator in a Littrow or Littman configuration, according to one of claims 1 to 10, comprising an optical grating (7) at which the light beam (16) of a laser diode (4) is diffracted, and a holding element (6) for holding the grating (7), wherein there is provided a diode holder (5) for holding the laser diode (4), wherein the diode holder (5) is mounted rotatably on the holding element (6) for adjusting the angle of incidence of the light beam (16) on the grating (7).

12. A diode laser system according to claim 11 **characterised in that** the diode holder (5) is of a substantially cylindrical configuration, wherein the holding element (6) for receiving the diode holder (5) has a recess corresponding to the shape thereof.

13. A diode laser system according to claim 11 or claim 12 **characterised by** at least one clamping block (22) which can be releasably
connected to the holding element (6) for fixing the diode holder (5) on the holding element (6).

## Revendications

1. Système de laser à diodes ajustable doté de résonateur externe dans une configuration de Littrow, d'un réseau (7) optique, sur lequel le faisceau laser (16) d'une diode laser (4) est diffracté, et d'un élément de retenue (6) pour la fixation du réseau (7), le système présentant un unique actionneur (12) pour la variation de la position du réseau (7), l'élément de retenue (6) comprenant un support (11), sur lequel le réseau (7) est disposé, et un corps de base (9), le support (11) étant relié au corps de base (9) par des articulations (13, 14) et sachant que, en ce qui concerne les articulations (13, 14), il s'agit d'articulations solides qui ont des degrés de liberté de translation et de rotation,
**caractérisé en ce que** l'actionneur (12) agit sur le support (11) et s'appuie sur le corps de base (9), et ce de telle sorte qu'une déviation linéaire de l'actionneur (12) en direction d'un axe de déviation (15) est transformée en une rotation du support (11) dans le plan du faisceau laser (16) qui est sous-tendu par le faisceau lumineux allant de la diode laser vers le réseau (7) et le faisceau lumineux réfracté par le réseau (7), le centre de rotation (17) se situant à l'extérieur d'une surface qui est sous-tendue par les articulations (13, 14) et à l'extérieur de la délimitation extérieure du corps de base (9), et les articulations solides comprenant des articulations de guidage (13) disposées des deux côtés de l'axe de déviation (15) et une articulation de rotation (14) qui est disposée de façon décalée latéralement par rapport à l'axe de déviation (15).

2. Système de laser à diodes ajustable doté de résonateur externe dans la configuration de Littman, doté d'un réseau (7) optique, sur lequel le faisceau lumineux (16) d'une diode laser (4) est diffracté, et d'un élément de retenue (6) pour la fixation d'un miroir, qui réfléchit la lumière diffractée sur le réseau (7), le système présentant un unique actionneur (12) pour la variation de la position du miroir, l'élément de retenue (6) comprenant un support (11), sur lequel le miroir est disposé, et un corps de base (9), le support (11) étant relié au corps de base (9) par des articulations (13, 14) et sachant que, en ce qui concerne les articulations (13, 14), il s'agit d'articulations solides qui ont des degrés de liberté de translation et de rotation, l'actionneur (12) s'appuyant sur le corps de base (9) et agissant sur le support (11) en ce sens qu'une déviation linéaire de l'actionneur (12) en direction d'un axe de déviation (15) est convertie en une rotation du support (11) dans le plan du faisceau lumineux (16) qui est sous-tendu par le faisceau lumineux allant de la diode laser à la grille (7) et le faisceau lumineux diffracté par le réseau (7), le centre de rotation (17) se situant à l'extérieur d'une surface qui est sous-tendue par les articulations (13, 14) et à l'extérieur de la délimitation du corps de base (9), et les articulations solides comprenant des articulations de guidage (13) disposées des deux côtés de l'axe de déviation (15) et une articulation de rotation (14) qui est disposée de façon décalée sur le côté par rapport à l'axe de déviation (15).

3. Système de laser à diodes ajustable selon la revendication 1 ou 2, **caractérisé en ce que** les articulations solides présentent une rigidité différente.

4. Système de laser à diodes ajustable selon l'une quelconque des revendications 1 à 3, **caractérisé en ce que** les articulations solides (13, 14) sont conçues sous forme d'articulations à plaque ou d'articulations avec ressort à lame.

5. Système de laser à diodes ajustable selon l'une quelconque des revendications 1 à 4, **caractérisé en ce que** la position du centre de rotation (17) peut être ajustée par la variation de la position du point d'influence de l'actionneur (12) sur le support (11).

6. Système de laser à diodes ajustable selon l'une quelconque des revendications 1 à 5, **caractérisé en ce que** l'actionneur (12) est un servomoteur linéaire, un actionneur piézoélectrique linéaire, ou une vis de réglage.

7. Système de laser à diodes ajustable selon l'une quelconque des revendications 1 à 6, **caractérisé en ce que** l'élément de retenue (6) comprend également un châssis tournant (8) sur lequel le corps de base (9) est monté à rotation dans le plan du faisceau lumineux (16).

8. Système de laser à diodes ajustable selon la revendication 7, **caractérisé en ce que** la longueur d'onde de la lumière émise par le système de laser à diodes peut être réglée par rotation du corps de base (9) par rapport au châssis tournant (8).

9. Système de laser à diodes ajustable selon l'une quelconque des revendications 1 à 8, **caractérisé par** un porte-diode (5) pour la fixation de la diode laser (4) et d'une optique de collimation (21), le porte-diode (5) pouvant tourner pour l'ajustage de l'angle d' arrivée du faisceau lumineux (16) sur la grille (7).

10. Système de laser à diodes ajustable selon la revendication 8 ou 9, **caractérisé en ce que** le porte-diode (5) est monté à rotation sur le châssis tournant (8), et ce autour d'un axe de rotation perpendiculaire à l'axe de rotation du corps de base (9).

11. Système de laser à diodes doté de résonateur externe dans la configuration de Littrow ou de Littman, selon l'une quelconque des revendications 1 à 10, d'un réseau (7) optique, sur lequel le faisceau lumineux (16) d'une diode laser (4) est diffracté, et d'un élément de retenue (6) pour la fixation du réseau (7), un porte-diode (5) étant prévu pour la fixation de la diode laser (4), le porte-diode (5) étant monté à rotation sur l'élément de retenue (6) pour l'ajustage de l'angle d'arrivée du faisceau lumineux (16) sur le réseau (7).

12. Système de laser à diodes selon la revendication 11, **caractérisé en ce que** le porte-diode (5) est conçu sensiblement cylindrique, l'élément de retenue (6) pour le logement du porte-diode (5) présentant un évidement correspondant à sa forme.

13. Système de laser à diodes ajustable selon la revendication 11 ou 12, **caractérisé par** au moins un bloc de serrage (22), pouvant être relié de façon amovible à l'élément de retenue (6), pour la fixation du porte-diode (5) sur l'élément de retenue (6).
